# FASCICULE DE BREVET EUROPEEN

(11) **EP 0 794 574 B1**
(45) Date de publication et mention de la délivrance du brevet: **08.01.2003**
(21) Numéro de dépôt: 97400495.4
(22) Date de dépôt: 04.03.1997
(51) Int. Cl.: H01L 25/065, H01L 21/98

(54) **Mémoire de masse et procédé de fabrication de mémoire de masse.**
Massenspeicher und Herstellungsverfahren dafür
Mass memory and method for its fabrication

(30) Priorité: 08.03.1996 FR 9602959
(43) Date de publication de la demande: 10.09.1997
(73) Titulaire: Thales, 75008 Paris (FR)
(72) Inventeur: Oudart, Myriam, Thomson-CSF, SCPI, 94117 Arcueil Cedex (FR); Bernard, François, Thomson-CSF, SCPI, 94117 Arcueil Cedex (FR); Bureau, Jean-Marc, Thomson-CSF. SCPI, 94117 Arcueil Cedex (FR)

(56) Documents cités:
- EP-A- 0 073 486
- EP-A- 0 238 066
- EP-A- 0 535 479
- EP-A- 0 644 548
- WO-A-89/04113
- WO-A-94/26083
- FR-A- 2 688 629
- US-A- 4 983 533
- US-A- 5 362 986
- CHANG-LEE CHEN ET AL: "BOND WIRELESS MULTICHIP PACKAGING TECHNOLOGY FOR HIGH-SPEED CIRCUITS" 1 Août 1992 , IEEE TRANSACTIONS ON COMPONENTS,HYBRIDS,AND MANUFACTURING TECHNOLOGY, VOL. 15, NR. 4, PAGE(S) 451 - 456 XP000311384 * figure 1 *

## Description

Le domaine de l'invention est celui des mémoires de masse haute densité, essentielles pour les systèmes de calcul de haute performance et pour les systèmes de stockage de données.

Actuellement des boîtiers comprenant une ou plusieurs puces, de plus en plus miniaturisées ont été développés pour ces applications et permettent de réduire la place occupée sur une carte d'interconnexion. Le fait de rapprocher les mémoires et les circuits de commande a en outre pour effet d'améliorer les performances électriques et en particulier diminuer les temps de propagation des signaux.

Ainsi, plutôt que d'organiser les puces côte à côte sur un substrat d'interconnexion plan, il a déjà été proposé d'empiler un certain nombre de puces nues, les unes sur les autres, afin d'augmenter encore la densité d'intégration et d'optimiser les longueurs d'interconnexion. Les circuits mémoires sont bien adaptés à ce type d'assemblage car ils dissipent peu de puissance et ils comportent un nombre relativement limité d'entrées/sorties. la plupart d'entre elles pouvant être connectées à des bus signaux communs à de nombreuses puces. De tels assemblages sont à l'heure actuelle réalisés par Texas Instruments, Irvine Sensors ou bien encore THOMSON-CSF (voir C-VAL, 9ème Conférence Européenne ISHM, Nice 1993, compte rendu p. 304 et revue R.T. CROWLEY et E.J. VARDAMAN dans MCM'94 proceedings). Un facteur de l'ordre de 100 en densité volumique peut ainsi être obtenu par rapport aux boîtiers traditionnels.

WO-A-8904113, EP-A-0073486 et FR-A-2688629 décrient des arrangements de puces connus dans l'état de la technique.

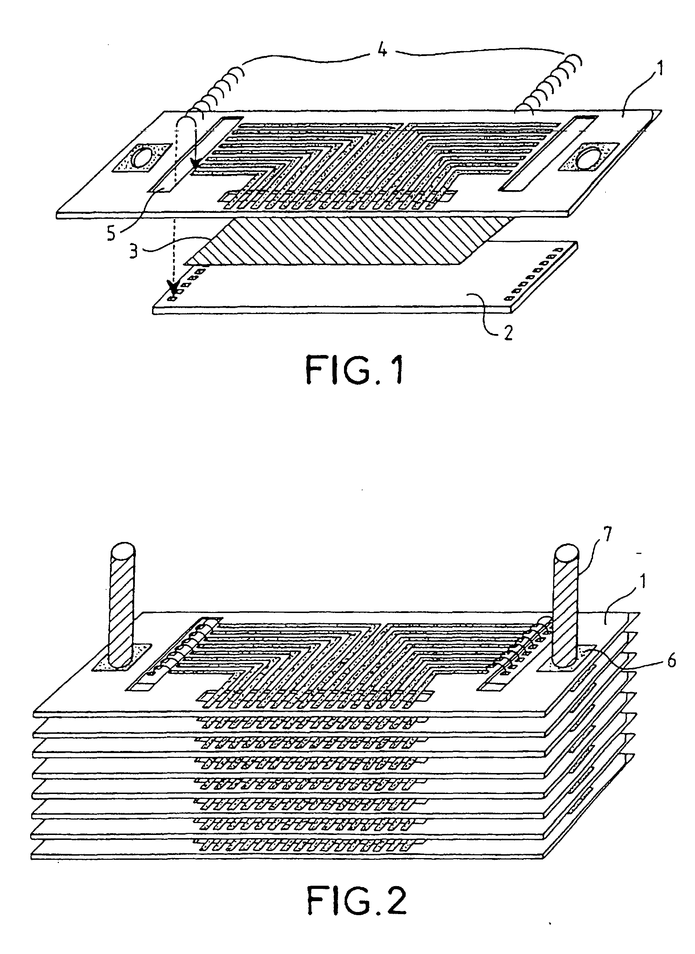

Les technologies employées nécessitent dans un premier temps une méthode de reconfiguration des entrées/sorties des puces sur un ou plusieurs côtés afin d'y avoir accès une fois l'empilement réalisé. Ceci peut être réalisé au niveau de la tranche de silicium ou bien au niveau de la puce découpée. La figure 1 illustre une de ces méthodes, où l'on reporte par collage et par câblage un circuit imprimé mince 1, à la surface de la puce 2, ce circuit imprimé ayant pour rôle de reporter les entrées/sorties situées dans le plan de la puce (par exemple sur ses deux petits côtés) à l'aide de pistes situées au-dessus de ce plan et arrivant en débord de celle-ci (par exemple sur un des grands côtés). Le collage de la puce sur le circuit imprimé peut être réalisé à l'aide d'un élément adhésif 3. Le câblage est effectué avec des fils 4, introduits dans des fenêtres 5 réalisées dans le circuit imprimé 1.

Après avoir été ainsi reconfigurées, un certain nombre de puces (par exemple 8) sont empilées et maintenues ensemble à l'aide de films adhésifs ou de résine liquide d'enrobage. La figure 2 illustre un tel empilement de puces reconfigurées. Dans le cas de l'exemple cité, les circuits imprimés minces possèdent également en débord de la puce des trous de centrage 6 qui permettent de positionner les puces entre elles lors de l'empilement. Les puces et les circuits imprimés sont superposés à l'aide de tiges de positionnement 7 et de cales permettant de fixer le pas d'un empilement. Cet assemblage est alors enrobé d'une réside liquide thermodurcissable qui va remplir tous les interstices et maintenir mécaniquement l'ensemble.

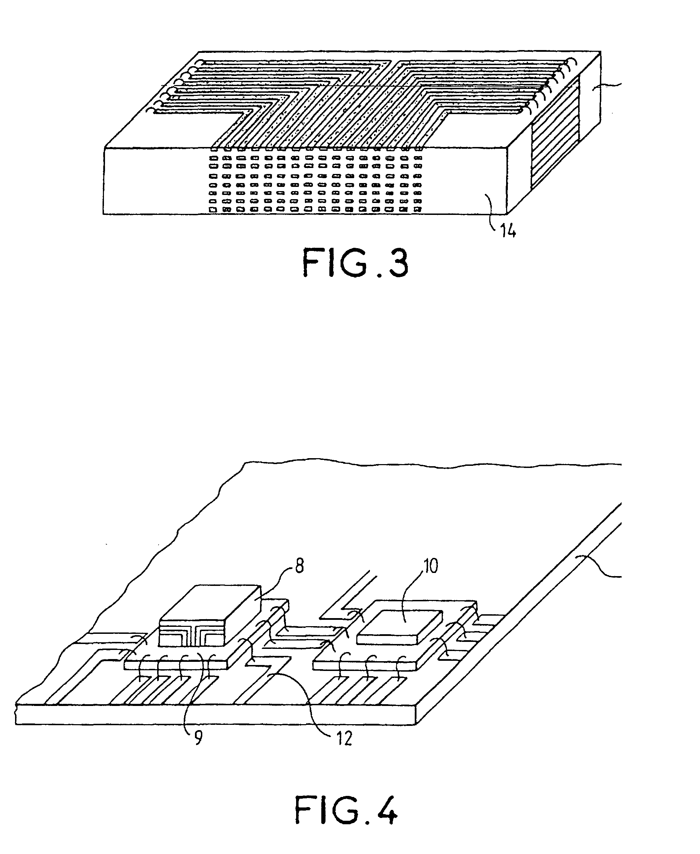

Le bloc tridimensionnel 8 ainsi réalisé est préparé sur la face donnant accès aux entrées/sorties des puces, pour pouvoir connecter celles-ci. Pour cela, la résine peut être usinée sur le côté qui contient les pistes en débord des puces de façon à obtenir une face plane de résine comprenant des plages métalliques correspondant aux sections desdites pistes comme l'illustre la figure 3.

Ces entrées/sorties sont alors interconnectées soit par métallisation et gravure pour constituer des pistes conductrices, soit par report par soudure sur un substrat d'interconnexion. La figure 4 illustre le report d'un bloc mémoire 8 comprenant plusieurs puces, sur un substrat d'interconnexion 9. Ce report permet généralement d'éclater le pas entre entrées/sorties contiguës pour disposer d'entrées/sorties facilement raccordables sur un circuit imprimé classique 11 comprenant un réseau d'interconnexion 12 permettant de relier le bloc mémoire 8 à un circuit de commande 10, également reporté sur le circuit imprimé 11.

La connexion d'un bloc 8 sur le substrat 9 peut typiquement être réalisée par câblage filaire, collage par résine conductrice, pattes ou billes métalliques.

L'ensemble bloc 8, circuit de commande 10, sur circuit imprimé 11 permet d'avoir une mémoire de masse fonctionnelle.

Pour augmenter davantage encore la densité de telles mémoires fonctionnelles, l'invention propose une nouvelle architecture de mémoire fonctionnelle, dans laquelle un macrobloc constitué d'un arrangement monolithique de blocs similaires aux blocs 8 précédemment décrits, constitue un substrat d'interconnexion, sur lequel on réalise un réseau d'interconnexion permettant de reporter directement les circuits de commande sur cedit réseau d'interconnexion.

Plus précisément, l'invention a pour objet une mémoire de masse fonctionnelle selon la rerendication 1, comprenant des blocs de puces empilées, connectés à des circuits de commande par l'intermédiaire d'un réseau d'interconnexion, caractérisée en ce qu'elle comprend un macrobloc constitué d'un arrangement matriciel de blocs de puces empilées, ledit arrangement monolithique constituant un substrat sur lequel sont superposés le réseau d'interconnexion et les circuits de commande.

L'invention a aussi pour objet un procédé de fabrication d'une mémoire de masse fonctionnelle, selon la revendication 5.

Plus précisément, il s'agit d'un procédé de fabrication de mémoire de masse fonctionnelle comprenant des blocs de puces empilées, dont une face comprend les sections de pistes conductrices reliées aux entrées/sorties des puces, un réseau d'interconnexion et des circuits de commande, caractérisé en ce qu'il comprend les étapes suivantes :
- la réalisation d'un macrobloc, constitué d'un arrangement matriciel de blocs de puces empilées, ledit macrobloc présentant une face sur laquelle apparaissent les sections de pistes ;
- la réalisation d'un réseau d'interconnexion sur la face du macrobloc ;
- la connexion de circuits de commande sur le réseau d'interconnexion.

L'invention sera mieux comprise et d'autres avantages apparaîtront à la lecture de la description qui va suivre, donnée à titre non limitatif et grâce aux figures annexées, parmi lesquelles :
- la figure 1 illustre une connexion électrique entre une puce et un circuit imprimé, pour reporter les entrées/sorties de la puce, selon l'art connu ;
- la figure 2 illustre un empilement de puces accolées à un circuit imprimé, selon l'art connu ;
- la figure 3 illustre un bloc de puces empilées, présentant une face sur laquelle apparaissent des sections de pistes conductrices connectées aux entrées/sorties des puces, selon l'art connu ;
- la figure 4 illustre une partie de mémoire de masse fonctionnelle selon l'art connu, dans laquelle les blocs de puces empilées sont connectés à des circuits de commande par l'intermédiaire de substrats de connexion et d'un réseau d'interconnexion standard ;
- la figure 5 illustre un premier exemple de connexion électrique entre une puce et un circuit imprimé, pouvant être utilisé dans l'invention ;
- la figure 6 illustre un second exemple de connexion électrique entre une puce et un circuit imprimé pouvant être utilisé dans l'invention ;
- la figure 7 illustre un empilement de puces et de circuits imprimés utilisés dans l'invention ;
- la figure 8 illustre une étape d'empilement de blocs 81, utilisée dans un exemple de procédé de fabrication de mémoire de masse fonctionnelle selon l'invention ;
- la figure 9 illustre un macrobloc constitué de l'arrangement matriciel de MxN blocs de puces empilées ;
- la figure 10 illustre une étape de réalisation de réseau d'interconnexion réalisé à la surface d'un macrobloc de l'invention ;
- la figure 11 illustre une mémoire de masse fonctionnelle selon l'invention comprenant des blocs de puces mémoires empilées, un réseau d'interconnexion et des circuits de commande.

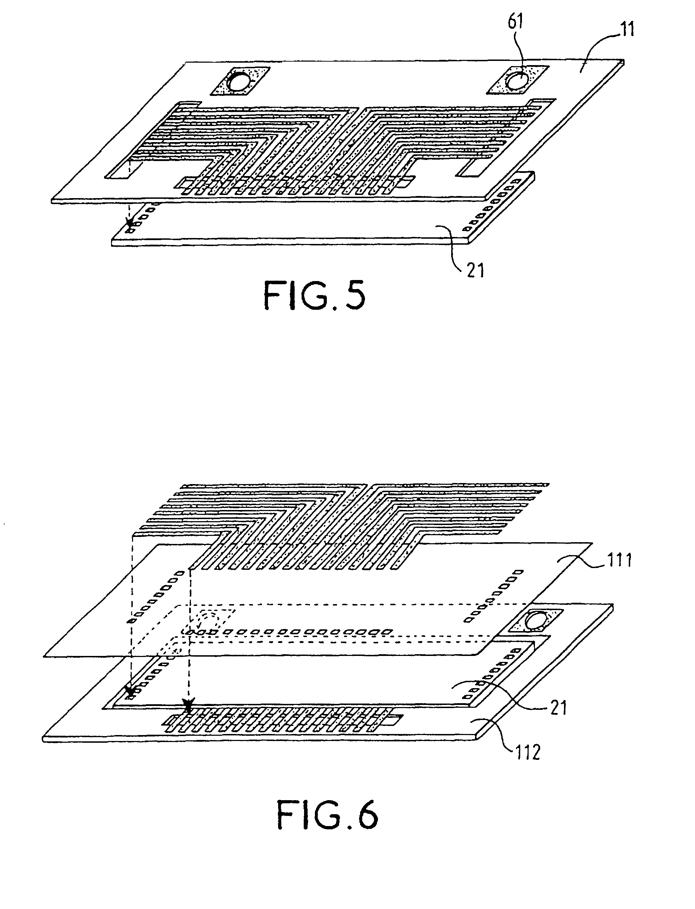

La mémoire de masse fonctionnelle selon l'invention est réalisée à partir de blocs élémentaires comprenant des mémoires reconfigurées existantes dans l'art connu. Il a été précédemment décrit en figure 1, une reconfiguration des entrées/sorties des puces mémoires en utilisant le câblage filaire, mais d'autres techniques peuvent être utilisées. On peut notamment reconfigurer les puces mémoires en prolongeant les pistes du circuit imprimé 11 jusqu'aux plots d'interconnexion de la puce 21, comme illustrée en figure 5. Chaque circuit imprimé 11 peut dans le cadre de l'invention présenter des trous de positionnement 61 et est réalisé à partir d'un circuit flexible ultramince (par exemple un film de polyimide de 50 µm d'épaisseur comprenant des pistes de cuivre de 35 µm d'épaisseur). On peut alors connecter directement ces pistes à la puce par thermocompression ou par laser.

La reconfiguration peut également être réalisée en utilisant un circuit souple évidé 112 comme illustré en figure 6, afin d'insérer la puce 21 de façon à ce que les surfaces du circuit souple et de la puce soient au même niveau ; on peut alors réaliser l'interconnexion en déposant (par exemple par laminage) un film sur cette surface, en perçant ledit film à l'endroit des entrées/sorties de la puce et du circuit souple, et en les raccordant par une métallisation déposée en couche mince.

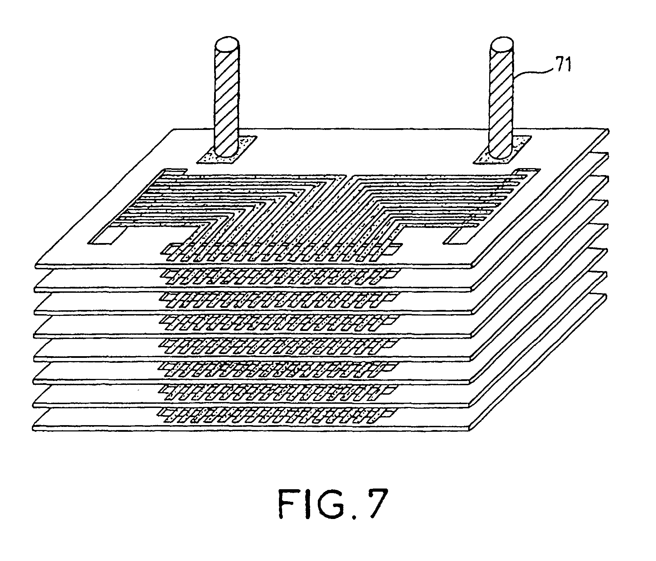

Les blocs de puces reconfigurées (par exemple de 8 puces) peuvent alors être réalisés par empilement d'ensembles circuit souple-puce. Pour cela, on intercale entre chaque ensemble puce-circuit souple, une préforme d'adhésif qui remplit tous les interstices et qui assure la tenue de l'ensemble du bloc. La figure 7 illustre un tel assemblage qui utilise des tiges de positionnement 71.

On découpe alors le bloc, perpendiculairement à l'empilement, de façon à laisser affleurer les sections des pistes en débord des puces.

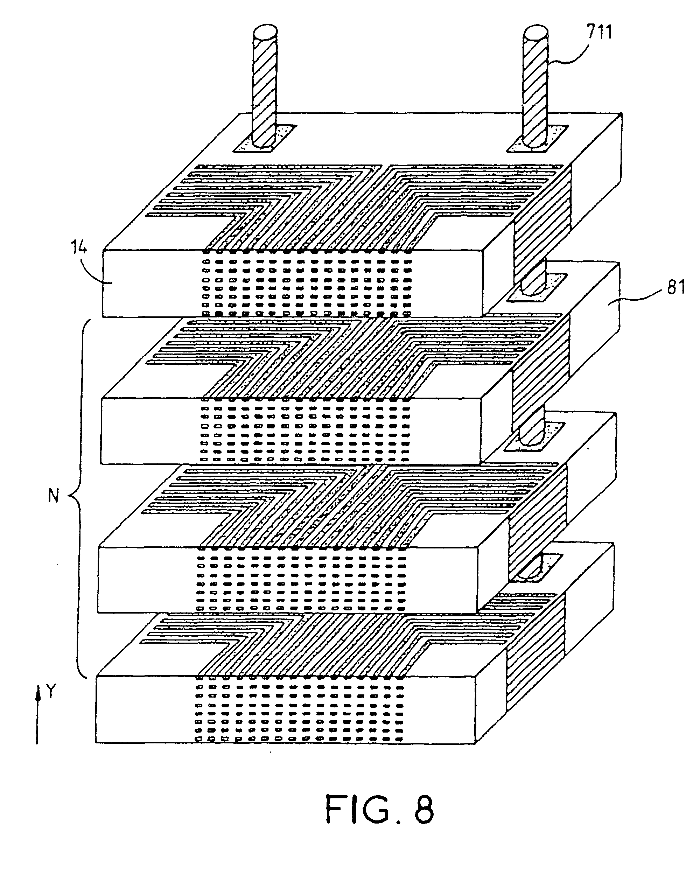

Selon un exemple de procédé selon l'invention, N blocs élémentaires 81, sont superposés selon une direction Y représentée en figure 8, en présentant la face 14 comportant les entrées/sorties, toujours du même côté.

La présence de trous de positionnement 711 dans chaque bloc 81, peut faciliter l'assemblage et le positionnement précis des blocs.

Dans un second temps, on accole M ensembles de N blocs élémentaires, selon une direction X orthogonale à la direction Y.

Pour réaliser ces différentes opérations d'assemblage, il est possible d'intercaler entre chaque bloc, ou chaque ensemble de blocs, des films d'adhésif, ou bien de surmouler l'ensemble dans une résine d'encapsulation.

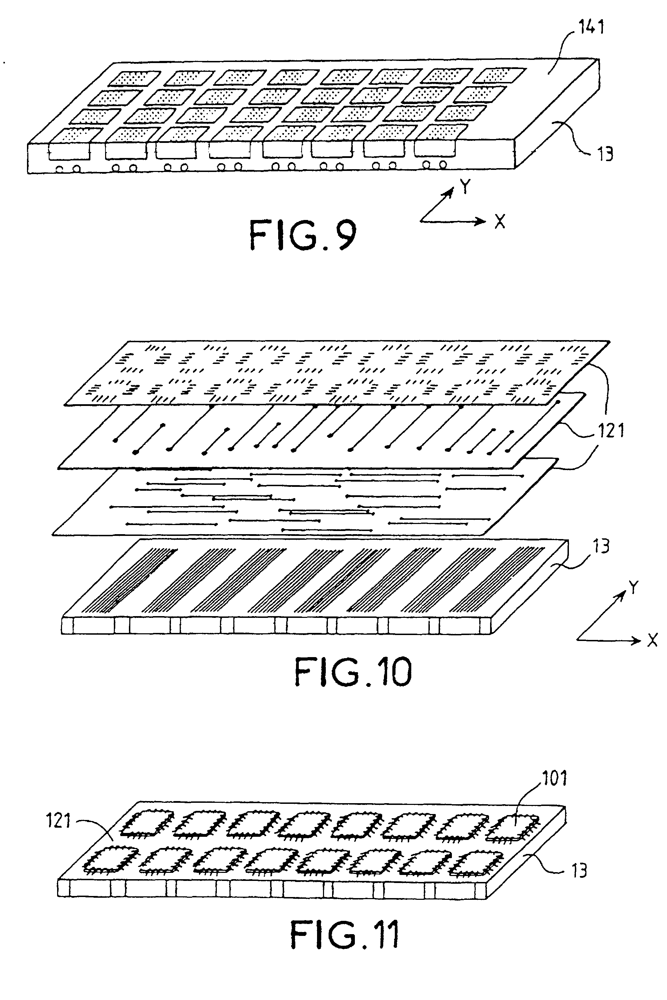

L'arrangement matriciel de MxN blocs élémentaires 81, constitue un macrobloc que l'on usine et dont on polit éventuellement la surface de façon à obtenir une surface plane 141, où affleurent toutes les sections des pistes correspondant aux entrées/sorties de chaque mémoire. La figure 9 illustre un tel macrobloc 13 avec sa face 141 comportant l'ensemble des sections de pistes représentatives des entrées/sorties de chaque puce.

Lors de l'assemblage de M ensembles de N blocs élémentaires, on peut insérer des éléments complémentaires fonctionnels de type connecteurs, drains thermiques dans le macrobloc 13.

Un des intérêts de l'invention réside dans l'utilisation de ce macrobloc 13 comme substrat d'interconnexion. En effet, selon le procédé de l'invention, on peut avantageusement réaliser un réseau d'interconnexion sur la face 141 du macrobloc 13.

Pour cela, les entrées/sorties des puces sont reliées électriquement de manière collective par un dépôt métallique, venant prendre contact sur chaque section de piste et on grave dans cette couche métallique des pistes conductrices selon l'architecture et le schéma électrique désiré.

Cette interconnexion peut être multicouches, en intercalant entre chaque niveau métallique, un niveau diélectrique percé de via, comme l'illustre la figure 10 faisant apparaître un niveau diélectrique mis en superposition avec le macrobloc 13, sur lequel on été réalisés préalablement des contacts électriques entre des blocs 81 alignés selon la direction Y. La réalisation du réseau d'interconnexion 121 peut faire appel aux procédés classiques des circuits imprimés de haute densité (dépôt de matériaux par laminage, perçage par laser, métallisations chimiques ou électrolytiques), de microélectronique (dépôts de diélectriques liquides, perçage par plasma ou gravure ionique, métallisation par évaporation ou pulvérisation sous vide) ou à toute combinaison de procédés connus dans l'état de la technique.

Pour réaliser la mémoire de masse fonctionnelle, on reporte sur le réseau d'interconnexion 121, les différentes puces de commande 101, sur des plages de report réalisées à cet effet sur la dernière couche du réseau d'interconnexion, comme illustré en figure 11. En l'occurrence les plages de report sont réalisées sur la couche supérieure du réseau d'interconnexion tel que représenté en figure 10.

Lorsque des connecteurs électriques ont été intégrés au macrobloc 13 lors de la fabrication, il est possible d'interconnecter directement entre elles, plusieurs mémoires de masse fonctionnelles, permettant de disposer d'une mémoire de très forte densité.

## Revendications

1. Mémoire de masse fonctionnelle, comprenant des blocs de puces empilées (81), connectés à des circuits de commande (101) par l'intermédiaire d'un réseau d'interconnexion (121), **caractérisée en ce qu'**elle comprend un macrobloc constitué d'un arrangement matriciel (13) de blocs de puces empilées (81), présentant une surface plane (141) où affleurent toutes les sections des pistes correspondant aux entrées/sorties de chaque mémoire, ledit arrangement matriciel forme un arrangement monolithique constituant un substrat sur lequel sont superposés le réseau d'interconnexion (121) et les circuits de commande (101).

2. Mémoire de masse fonctionnelle selon la revendication 1, **caractérisée en ce que** le macrobloc (13) comprend des éléments complémentaires conducteurs thermiques ou électriques.

3. Mémoire de masse fonctionnelle selon l'une des revendications 1 ou 2, **caractérisée en ce qu'**elle comprend de la résine entre les blocs de puces encapsulées (81).

4. Mémoire de masse fonctionnelle selon l'une des revendications 1 ou 2, **caractérisée en ce qu'**elle comprend des films adhésifs entre des rangées de blocs de puces (81).

5. Procédé de fabrication de mémoire de masse fonctionnelle comprenant des blocs de puces empilées (81), dont une face (14) comprend les sections de pistes (15) conductrices reliées aux entrées/sorties des puces, un réseau d'interconnexion (121) et des circuits de commande (101), **caractérisé en ce qu'**il comprend les étapes suivantes :
- la réalisation d'un macrobloc, constitué d'un arrangement matriciel monolithique (13) de blocs de puces empilées (81), ledit macrobloc présentant une surface plane (141) sur laquelle apparaissent toutes les sections de pistes (15) ;
- la réalisation d'un réseau d'interconnexion (121) sur la surface plane (141) du macrobloc (13) ;
- la connexion de circuits de commande (101) sur le réseau d'interconnexion (121).

6. Procédé de fabrication de mémoire de masse fonctionnelle selon la revendication 5, **caractérisé en ce que** la réalisation du macrobloc comprend :
- l'usinage de trous de positionnement (61) dans les blocs (81) selon une direction (Y) perpendiculaire au plan des puces ;
- M empilements de N blocs (81) selon la direction (Y) en introduisant des tiges de positionnement (711) dans les trous de positionnement (61);
- l'assemblage des M empilements selon une direction (X) perpendiculaire à la direction (Y).

7. Procédé de fabrication de mémoire de masse fonctionnelle selon l'une des revendications 5 ou 6, **caractérisé en ce qu'**il comprend :
- la réalisation du macrobloc (13) par surmoulage de l'ensemble des blocs (81) dans une résine d'encapsulation ;
- l'usinage et le polissage, du surmoulage de l'ensemble des blocs (81) de manière à rendre apparente la face (141) du macrobloc (13).

8. Procédé de fabrication de mémoire de masse fonctionnelle selon l'une des revendications 5 à 7, **caractérisé en ce qu'**il comprend l'élaboration d'un réseau d'interconnexion (121) par dépôts alternatifs de couches métalliques et de couches diélectriques percés de via.

## Patentansprüche

1. Funktionaler Massenspeicher mit Blöcken (81) von gestapelten Chips, die an Steuerschaltungen (101) über ein Leiternetz (121) angeschlossen sind, **dadurch gekennzeichnet, daß** er einen Makroblock enthält, der von einer matrixartigen Anordnung (13) von Blöcken (81) gestapelter Chips gebildet wird und eine ebene Oberfläche (141) besitzt, an der alle Querschnitte von Leiterbahnen entsprechend den Eingängen und Ausgängen jedes Speichers zu Tage treten, wobei die matrixförmige Anordnung eine monolithische Anordnung bildet, die ein Substrat bildet, auf das das Leiternetz (121) und die Steuerschaltungen (101) aufgebracht sind.

2. Funktionaler Massenspeicher nach Anspruch 1, **dadurch gekennzeichnet, daß** der Makroblock (13) komplementäre Wärmeleiter oder elektrische Leiter enthält.

3. Funktionaler Massenspeicher nach einem der Ansprüche 1 und 2, **dadurch gekennzeichnet, daß** er Harz zwischen den Blöcken (81) von eingekapselten Chips aufweist.

4. Funktionaler Massenspeicher nach einem der Ansprüche 1 und 2, **dadurch gekennzeichnet, daß** er Klebefolien zwischen Reihen von Chipblöcken (81) enthält.

5. Verfahren zur Herstellung eines funktionalen Massenspeichers mit Blöcken (81) gestapelter Chips, die an einer Seite (14) die Querschnitte von an die Eingänge und Ausgänge der Chips angeschlossenen Leiterbahnen (15), ein Leiternetz (121) und Steuerschaltungen (101) aufweisen, **dadurch gekennzeichnet, daß** es folgende Schritte aufweist:
- Herstellung eines Makroblocks bestehend aus einer matrixförmigen monolithischen Anordnung (13) von Blöcken (81) gestapelter Chips, wobei der Makroblock eine ebene Fläche (141) aufweist, auf der alle Querschnitte von Leiterbahnen (15) zu Tage treten,
- Herstellung eines Leiternetzes (121) auf der ebenen Fläche (141) des Makroblocks (13),
- Verbindung der Steuerschaltungen (101) mit dem Leiternetz (121).

6. Verfahren zur Herstellung eines funktionalen Massenspeichers nach Anspruch 5, **dadurch gekennzeichnet, daß** zur Herstellung des Makroblocks folgende Schritte gehören:
- Bildung von Positionierlöchern (61) in den Blöcken (81) gemäß einer Richtung (Y) senkrecht zur Ebene der Chips,
- Bildung von M Stapeln aus je N Blöcken (81) in Stapelrichtung Y, wobei Positionierstäbe (711) in die Positionierlöcher (61) gesteckt werden,
- Zusammenbau der M Stapel in Richtung X senkrecht zur Richtung Y.

7. Verfahren zur Herstellung von Massenspeichern nach einem der Ansprüche 5 und 6, **dadurch gekennzeichnet, daß** es folgende Schritte aufweist:
- Herstellung des Makroblocks (13) durch Einbetten der Gesamtheit von Blöcken (81) in ein Versiegelungsharz,
- Bearbeitung und Abschleifen des Harzes an der Gesamtheit der Blöcke (81), bis die Fläche (141) des Makroblocks (13) sichtbar wird.

8. Verfahren zur Herstellung eines funktionalen Massenspeichers nach einem der Ansprüche 5 bis 7, **dadurch gekennzeichnet, daß** es die Bildung eines Leiternetzes (121) durch abwechselndes Aufbringen von Metallschichten und dielektrischen Schichten mit Durchlässen enthält.

## Claims

1. Functional mass memory comprising blocks of stacked chips (81) connected to control circuits (101) by means of an interconnection network (121), **characterized in that** it comprises a macroblock constituted by a matrix arrangement (13) of blocks of stacked chips (81) and having a plane surface (141) with which all the sections of the tracks corresponding to the inputs/outputs of each memory are flush, the said matrix arrangement forming a monolithic arrangement constituting a substrate on which the interconnection network (121) and the control circuits (101) are superimposed.

2. Functional mass memory according to Claim 1, **characterized in that** the macroblock (13) comprises thermally or electrically conductive complementary elements.

3. Functional mass memory according to either of Claims 1 and 2, **characterized in that** it comprises resin between the encapsulated blocks of chips (81).

4. Functional mass memory according to either of Claims 1 and 2, **characterized in that** it comprises adhesive films between rows of blocks of chips.

5. Method for the manufacture of a functional mass memory comprising blocks of stacked chips (81) one face (14) of which comprises sections of conductive tracks (15) connected to the inputs/outputs of the chips, an interconnection network (121) and control circuits (101), **characterized in that** it comprises the following steps:
- the making of a macroblock formed by a monolithic matrix arrangement (13) of blocks of stacked chips (81), said macroblock having a plane surface (141) on which the track sections (15) appear;
- the making of an interconnection network (121) on the plane surface (141) of the macroblock (13);
- the connection of control circuits (101) to the interconnection network (121).

6. Method for the manufacture of a functional mass memory according to Claim 5, **characterized in that** the making of the macroblock comprises:
- the machining of positioning holes (61) in the blocks (81) in a direction (Y) perpendicular to the plane of the chips;
- the making of M stacks of N blocks (81) in the direction (Y) while introducing positioning rods (711) into the positioning holes (61);
- the assembling of the M stacks in a direction (X) perpendicular to the direction (Y).

7. Method for the manufacture of a functional mass memory according to either of Claims 5 and 6, **characterized in that** it comprises:
- the making of the macroblock (13) by the encapsulation of the set of blocks (81) in an encapsulation resin;
- the machining and polishing of the encapsulation of the set of blocks (81) so as to reveal the face (141) of the macroblock (13).

8. Method for the manufacture of a functional mass memory according to one of Claims 5 to 7, **characterized in that** it comprises the making of an interconnection network (121) by alternately depositing metal layers and dielectric layers drilled with vias.
